# EUROPÄISCHE PATENTSCHRIFT

(11) **EP 4 374 179 B1**
(45) Veröffentlichungstag und Bekanntmachung des Hinweises auf die Patenterteilung: **22.10.2025**
(21) Anmeldenummer: 22748051.4
(22) Anmeldetag: 19.07.2022
(51) Int. Cl.: G01R 15/18, H01B 17/00

(54) **STROMSENSORSPULENANORDNUNG**
CURRENT SENSOR COIL ASSEMBLY
ENSEMBLE BOBINE DE CAPTEUR DE COURANT

(30) Priorität: 21.07.2021 AT 506052021
(43) Veröffentlichungstag der Anmeldung: 29.05.2024
(73) Patentinhaber: Egston System Electronics Eggenburg GmbH, 3730 Eggenburg (AT)
(72) Erfinder: JAMY, Roman, 3593 Neupölla (AT); PRAND-STRITZKO, Ernst, 2091 Langau (AT); ERDÖSI, Daniel, 3730 Eggenburg (AT); HÖGENAUER, Martin, 3730 Eggenburg (AT)
(74) Vertreter: Gibler & Poth Patentanwälte KG
(86) Internationale Anmeldenummer: PCT/EP2022/070180
(87) Internationale Veröffentlichungsnummer: WO 2023/001811

(56) Entgegenhaltungen:
- EP-A1- 1 302 773
- EP-A1- 3 965 126
- EP-B1- 0 901 705
- WO-A1-2009/139521
- DE-A1- 2 002 192
- DE-A1- 4 429 959
- US-A- 4 091 139
- US-A1- 2011 140 694

## Beschreibung

Die Erfindung betrifft eine Stromsensorspulenanordnung gemäß dem Oberbegriff des Patentanspruches 1.

Es sind Strommessanordnungen bekannt, welche eine gewickelte Ringkernspule als eigentliches Sensorelement aufweisen, welche Ringkernspule die zu messende Stromleitung voll umfasst, ohne jedoch mit dieser direkt mechanisch verbunden zu sein.

Dabei sind unterschiedliche Stromsensorspulenanordnungen bekannt, welche jeweils Spulen aufweisen, welche einen Primärleiter einer zu messenden elektrischen Leitung umfassen. Bekannt sind dabei insbesondere Eisenkernspulen, welche in einem Stahlblechgehäuse angeordnet sind.

Derartige Strommessanordnungen weisen eine Vielzahl an Problemen bzw. Fehlern auf, wie etwa ein äußerst geringes messbares Frequenzband im Primärleiter, eine geringe Messgenauigkeit, eine hohe Baugröße, eine leichte Beeinflussbarkeit durch elektrische Felder in der Umgebung usw. Selbst bei Messungen an einem 50Hz Netzwerk bei geringen elektrischen Umgebungsfeldern weisen derartige Stromsensorspulenanordnungen Abweichungen von 1% bis 10% auf, und sind daher für detaillierte Aufnahmen nur bedingt geeignet. In Umgebungen mit starken bzw. sehr ausgeprägten Feldern, wie etwa im Ausstrahlgebiet von Flugnavigationssendern (z.B.: ILS), und/oder hochfrequenten Teilströmen im Primärleiter, wie etwa verursacht durch Computeranlagen, treten weitere Fehler bzw. Probleme auf. Eingestrahlte elektrische Felder können neben der Beeinflussung des Messvorganges weiters noch Wirbelströme im Gehäuse verursachen. Teilströme mit höheren Frequenzen können zu Messfehlern führen bzw. dazu, dass aufgrund der hochfrequenten Ströme auch die niederfrequenten Ströme nicht mehr gemessen werden können.

Derartige Stromsensorspulenanordnungen sind in deren Anwendungsbereichen sehr eingeschränkt, und können nur dann verwendet werden, wenn eine hohe Messgenauigkeit der Stromstärke irrelevant ist. Derartige Anlagen können daher in der modernen Gegenwart, in welche sowohl hochfrequente Ströme als auch zahlreiche elektrische Felder vorherrschend sind, nicht mehr für detaillierte Messungen verwendet werden, sondern lediglich einer Grobabschätzung dienen, sind jedoch weder für Sicherheitszwecke noch für andere wichtige Messungen einsetzbar.

Es ist weiters bekannt gewickelte Ringkernspulen als Rogowskispule auszubilden. Jedoch werden derartige Rogowskispulen vor allem für einzelne Sonderverwendungen eingesetzt.

Die EP 1 302 773 A1 offenbart eine Sensoranordnung, welche mehrere - in Serie geschaltete Spulen aufweist, welche gemeinsam eine Rogowskispule bilden. Die einzelnen Spulen befinden sich in einem Gehäuse aus einem Halbleiter. Die Zwischenräume im Gehäuse sind mit einem Harz gefüllt.

Die US 2011/0140694 A1 beschreibt eine Rogowskispule, welche zum mechanischen Schutz eine Ummantelung aufweist.

Die DE 2 002 192 A1 beschreibt einen Hochspanungstransformator mit einem isolierten Kern.

Die WO 2009/139521 A1 zeigt unter anderem eine Rogowskispule, welche in einem Gehäuse angeordnet ist, wobei sich auf einer Seite Epoxy-Hart befindet, welches die Rogowskispule in dem Gehäuse hält.

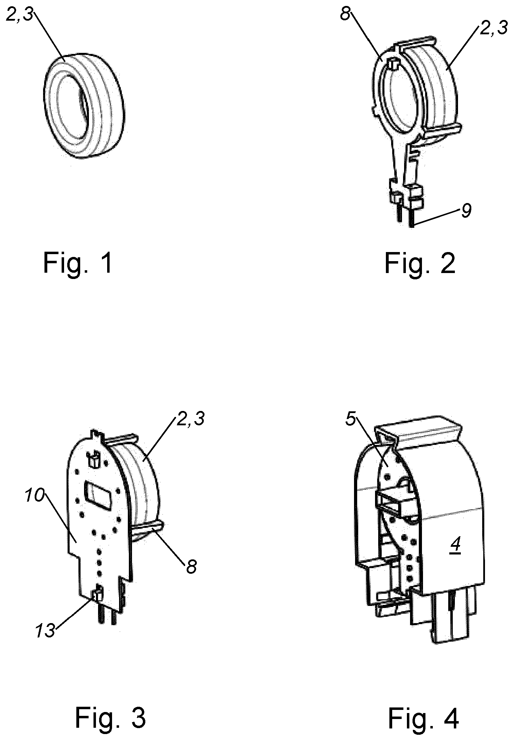

Die DE 44 29 959 A1 beschreibt einen Stromwandler mit einer Rogowskispule, welche in einem Gehäuse angeordnet ist, wobei gemäß Fig. 3 eine leitende oder halbleitende Masse zwischen dem Gehäuse und der Rogowskispule angeordnet ist.

Aufgabe der Erfindung ist es daher eine Stromsensorspulenanordnung der eingangs genannten Art anzugeben, mit welcher die genannten Nachteile vermieden werden können, mit welcher eine hohe Messgenauigkeit erreicht werden kann, welche in weiten Bereichen einsetzbar ist, und welche einfach und sicher herstellbar ist.

Erfindungsgemäß wird dies durch die Merkmale des Patentanspruches 1 erreicht.

Dadurch kann eine Stromsensorspulenanordnung mit einer Rogowskispule geschaffen werden, welche als Stromzähler in einem Energieversorgungsnetzwerk, insbesondere umfassend Smart-Grids, einsetzbar ist.

Dadurch kann eine vorgebbare elektromagnetische Abschirmung erreicht werden. Dadurch kann die Messgenauigkeit deutlich erhöht werden, und gleichzeitig kann sichergestellt werden, dass die Messung nicht manipulierbar ist. Dadurch kann eine geringe kapazitive Kopplung erreicht werden.

Dadurch kann eine galvanische Trennung der Stromsensorspulenanordnung zu den zu messenden Leitern, welche auch als Primärleiter bezeichnet werden, sichergestellt werden. Es kann eine Potentialentkopplung sichergestellt werden, wodurch das Messsignal nicht gestört wird.

Dadurch kann hinsichtlich der messtechnischen Erfassung ein deutlich weiterer Frequenzbereich als bei herkömmlichen Eisenkernen erzielt werden.

Weiters kann dadurch ein im Wesentlichen lineares Sättigungsverhalten erzielt werden.

Durch das hochohmig leitfähige Vergussmittel werden Wirbelströme gering gehalten, wodurch die Messgenauigkeit erhöht werden kann. Zudem führt die hochohmige Leitfähigkeit des Vergussmittels auch zu einer ausreichenden Entkoppelung des Gehäuses der Stromsensorspulenanordnung von der Rogowskispule.

Sowohl hinsichtlich des mechanischen Aufbaues als auch der elektromagnetischen Wirksamkeit weist die Stromsensorspulenanordnung eine sehr effektive Schirmung auf. Insbesondere Stromsensorspulenanordnungen, welche lediglich eine geringe Baugröße aufweisen, können derart sehr gut geschirmt werden. Eine geringe Baugröße ist insbesondere eine Rogowskispule mit einem Innendurchmesser von 5 mm - 20 mm.

Ein derartiges Vergussmittel ist zudem einfach verarbeitbar und hinsichtlich der Anschaffung und der Verarbeitung kostengünstig.

Die Erfindung betrifft ein Verfahren zur Herstellung einer Stromsensorspulenanordnung gemäß dem Oberbegriff des Patentanspruches 11.

Aufgabe der Erfindung ist es daher ein Verfahren zur Herstellung einer Stromsensorspulenanordnung anzugeben, mit welcher die eingangs genannten Nachteile vermieden werden können, mit welcher einfach und sicher eine Stromsensorspulenanordnung mit hoher Messgenauigkeit und weitem Einsatzbereich herstellbar ist.

Erfindungsgemäß wird dies durch die Merkmale des Patentanspruches 11 erreicht.

Dadurch können die vorstehend angeführten Vorteile erreicht werden.

Die Unteransprüche betreffen weitere vorteilhafte Ausgestaltungen der Erfindung.

Ausdrücklich wird hiermit auf den Wortlaut der Patentansprüche Bezug genommen, wodurch die Patentansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 eine schematische Darstellung einer, als Rogowskispule ausgebildeten gewickelten Ringkernspule;
Fig. 2 ein Verbund aus der Rogowskispule und einem Halteteil;
Fig. 3 die Anordnung gemäß Fig. 2 befestigt an einer Schirmplatte;
Fig. 4 ein Gehäuse mit darin angeordnetem Vergussmittel;
Fig. 5 die Anordnung gemäß Fig. 3 in Einbauposition vor der Anordnung gemäß Fig. 4;
Fig. 6 eine Stromsensorspulenanordnung bestehend aus der Anordnung gemäß Fig. 3 welche sich innerhalb der Anordnung gemäß Fig. 4 befindet;
Fig. 7 eine Schnittdarstellung durch ein Gehäuse während des Einbringens der Anordnung gemäß Fig. 3;
Fig. 8 die Anordnung gemäß Fig. 7 nach einem vollständigen Einbringvorgang;
Fig. 9 eine Schnittdarstellung durch die Stromsensorspulenanordnung gemäß Fig. 8, wobei der Schnittwinkel in 90 Grad zu den Fig. 7 und 8 angeordnet ist;
Fig. 10 die Anordnung gemäß Fig. 3 mit einem schematisch dargestellten Gehäuse;
Fig. 11 die Anordnung gemäß Fig. 10 unter Darstellung eines vollständig verformten Vergussmittels; und
Fig. 12 eine vollständige Stromsensorspulenanordnung.

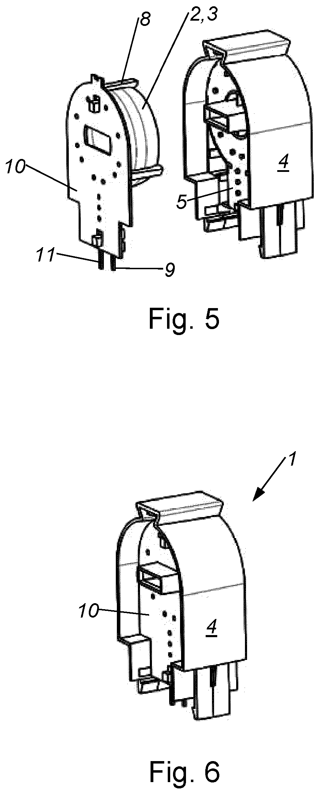

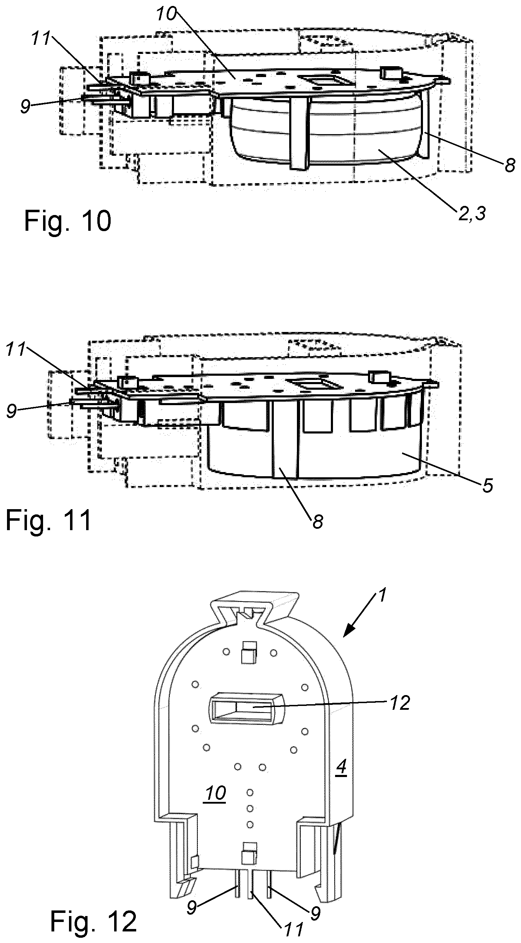

Die Fig. 1 bis 12 zeigen eine Stromsensorspulenanordnung 1 umfassend wenigstens eine Sensor-Luftspule 2, welche Sensor-Luftspule 2 als Rogowskispule 3 ausgebildet ist, wobei die Stromsensorspulenanordnung 1 ein Gehäuse 4 aufweist, welches Gehäuse 4 die Rogowskispule 3 umfasst, wobei die Rogowskispule 3 in ein Vergussmittel 5 eingebettet ist, wobei das Vergussmittel 5 wenigstens einen ersten Werkstoff und einen zweiten Werkstoff umfasst, wobei der erste Werkstoff ein elektrischer Isolierstoff ist, wobei der zweite Werkstoff Partikel mit vorgebbarer elektrischer Leitfähigkeit umfasst, und wobei das Vergussmittel 5 einen spezifischen elektrischen Widerstand zwischen 1 500 Ω·cm und 5000 Ω·cm, vorzugsweise zwischen 2000 Ω·cm und 3000 Ω·cm, aufweist. Die Fig. 6 und 12 zeigen dabei Vollansichten der Stromsensorspulenanordnung 1 im fertigungstechnischen Endzustand.

Dadurch kann eine Stromsensorspulenanordnung mit einer Rogowskispule geschaffen werden, welche als Stromzähler in einem Energieversorgungsnetzwerk, insbesondere umfassend Smart-Grids, einsetzbar ist.

Dadurch kann eine vorgebbare elektromagnetische Abschirmung erreicht werden. Dadurch kann die Messgenauigkeit deutlich erhöht werden, und gleichzeitig kann sichergestellt werden, dass die Messung nicht manipulierbar ist. Dadurch kann eine geringe kapazitive Kopplung erreicht werden.

Dadurch kann eine galvanische Trennung der Stromsensorspulenanordnung zu den zu messenden Leitern, welche auch als Primärleiter bezeichnet werden, sichergestellt werden. Es kann eine Potentialentkopplung sichergestellt werden, wodurch das Messsignal nicht gestört wird.

Dadurch kann hinsichtlich der messtechnischen Erfassung ein deutlich weiterer Frequenzbereich als bei herkömmlichen Eisenkernen erzielt werden.

Weiters kann dadurch ein im Wesentlichen lineares Sättigungsverhalten erzielt werden.

Durch das hochohmig leitfähige Vergussmittel werden Wirbelströme gering gehalten, wodurch die Messgenauigkeit erhöht werden kann. Zudem führt die hochohmige Leitfähigkeit des Vergussmittels auch zu einer ausreichenden Entkoppelung des Gehäuses der Stromsensorspulenanordnung von der Rogowskispule.

Sowohl hinsichtlich des mechanischen Aufbaues als auch der elektromagnetischen Wirksamkeit weist die Stromsensorspulenanordnung eine sehr effektive Schirmung auf. Insbesondere Stromsensorspulenanordnungen, welche lediglich eine geringe Baugröße aufweisen, können derart sehr gut geschirmt werden. Eine geringe Baugröße ist insbesondere eine Rogowskispule mit einem Innendurchmesser von 5 mm - 20 mm.

Ein derartiges Vergussmittel ist zudem einfach verarbeitbar und hinsichtlich der Anschaffung und der Verarbeitung kostengünstig.

Wie eingangs bereits dargelegt sind Stromsensorspulenanordnung 1 mit gewickelten Ringkernspulen bzw. Sensor-Luftspulen 2 seit langem bekannt. Die Nachteile dieses Standes der Technik wurden bereits dargelegt.

Weiters ist es bekannt, eine Rogowskispule 3 als Sensor-Luftspule 2 zu verwenden.

Es hat sich gezeigt, dass die Verwendung eines Vergussmittels 5 an sich, welches um weite bzw. wesentliche Teile der Rogowskispule 3 herum angeordnet ist, einen Einfluss auf die Messgenauigkeit haben kann. Es hat sich weiters gezeigt, dass die Ausführung bzw. die Art des Vergussmittels 5 und/oder die Art der Anordnung bzw. der Positionierung desselbigen an bzw. bezugnehmend auf die Rogowskispule 3 einen hohen Einfluss auf die Messgenauigkeit hat.

Gegenständlich ist diese Sensor-Luftspule 2 als Rogowskispule 3 ausgebildet. Rogowskispulen 3 sind hinsichtlich deren grundsätzlichen Aufbaues ebenfalls bekannt, und werden dahingehend gegenständlich nicht näher beschrieben.

Die Stromsensorspulenanordnung 1 weist ein Gehäuse 4 auf, in welchem die Rogowskispule 3 angeordnet ist, und welches diese umgibt bzw. umschließt. Das Gehäuse 4 ist bevorzugt umfassend Kunststoff ausgebildet, wobei jedoch das Gehäuse 4 auch aus Metall ausgebildet sein kann. Weiters kann das Gehäuse eine Kombination von Metall und Kunststoff aufweisen.

Das Gehäuse 4 weist zudem eine Öffnung 12 entsprechend des Innenfreibereiches der Rogowskispule 3 auf, sodass es nach wie vor möglich ist, einen elektrischen Leiter mit der Rogowskispule 3 zu umschließen. In dem Gehäuse 4 befinden sich zudem noch weitere Bauteile bzw. Baugruppen, sofern die Stromsensorspulenanordnung 1 solche umfasst, wie dies gegenständlich bevorzugt vorgesehen ist.

Die Fig. 1 bis 9 zeigen jeweils unterschiedliche Zeitpunkte des Ablaufes eines Verfahrens zur Herstellung einer Stromsensorspulenanordnung 1, wobei eine Rogowskispule 3 an einem Halteteil 8 befestigt wird, wobei die Rogowskispule 3 an elektrische Verbindungsmittel 9 der Stromsensorspulenanordnung 1 angeschlossen wird, wobei die angeschlossene Rogowskispule 3 zusammen mit dem Halteteil 8 einseitig mit einer Schirmplatte 10 verbunden wird, wobei eine vorgebbare Menge eines Vergussmittels 5 mit einem spezifischen elektrischen Widerstand zwischen 10 Ω·cm und 6000 Ω·cm, insbesondere mit einer Viskosität zwischen 1 Pa·s und 1000 Pa·s, in ein Gehäuse 4 der Stromsensorspulenanordnung 1 eingeführt wird, wobei nachfolgend die Anordnung aus angeschlossener Rogowskispule 3, Halteteil 8 und Schirmplatte 10 in das Gehäuse 4 eingeführt und gegen das Vergussmittel 5 gepresst wird, wobei das Vergussmittel 5 verformt wird und ein Volumen zwischen der Rogowskispule 3 und einer Innenfläche 7 des Gehäuses 4 in vorgebbarem Maße ausfüllt.

Fig. 1 zeigt eine schematische Darstellung der Rogowskispule 3. Die Rogowskispule 3 wird an einem Halteteil 8 befestigt. Fig. 2 zeigt eine Darstellung einer Rogowskispule 3 und eines daran befestigten Halteteiles 8. Die Rogowskispule 3 wird weiters an elektrische Verbindungsmittel 9 bzw. Anschlussteile bzw. elektrische Kontaktstöcke der Stromsensorspulenanordnung 1 angeschlossen. Dieser Anschluss ist erforderlich, kann jedoch beim Aufbau bzw. der Herstellung der Stromsensorspulenanordnung 1 dann durchgeführt werden, wenn dies fertigungstechnisch vorteilhaft ist.

Die Kombination aus elektrisch angeschlossener Rogowskispule 3 und an dieser befestigtem Halteteil 8 wird an einer Seite mit einer Schirmplatte 10 verbunden. Fig. 3 zeigt eine solche Anordnung. Dabei wird die Schirmplatte 10 auf dem Halteteil 8 angeordnet und daran befestigt. Der Halteteil 8 weist dazu bevorzugt zwei oder mehr Einrastschienen 13 auf, welche entsprechend ausgebildete Kontaktierungsöffnungen der Schirmplatte 10 durchgreifen. Die entsprechenden Befestigungsteile können jedoch auch anders ausgebildet sein und/oder anstatt auf dem Halteteil 8 auf der Schirmplatte 10 angeordnet sein.

Bevorzugt ist vorgesehen, dass die Rogowskispule 3 elektrisch überprüft wird. Dabei wird eine elektrische Messung an der Rogowskispule 3 durchgeführt, um deren Eigenschaften zu detektieren. Dadurch können allfällige Fehler erkannt werden und gegebenenfalls eine weitere Verwendung bzw. ein Einbau in die Stromsensorspulenanordnung 1 bestimmter Rogowskispulen 3 vermieden werden. Es ist vorteilhaft, wenn diese Überprüfung vor einer weiteren Verwendung der Rogowskispule 3, etwa einem Einbau in das Gehäuse 4 erfolgt.

Die Rogowskispule 3 wird in das Gehäuse 4 eingebracht. Bevor dies erfolgt, wird eine vorgebbare Menge eines Vergussmittels 5 in das Gehäuse 4 eingegebracht bzw. dort angeordnet. Fig. 4 zeigt eine Gehäuse 4 mit einem darin angeordneten Vergussmittel 5. Dabei weist das dargestellte Vergussmittel 5 bereits eine Form auf, als ob dieses bereits teilweise bzw. vollständig verformt worden wäre, was jedoch noch nicht der Fall ist. Auf die speziellen Eigenschaften des Vergussmittels 5 wird noch eingegangen.

Nachdem das Vergussmittel 5 in das Gehäuse 4 eingebracht wurde, wird die Anordnung aus - miteinander verbundener - Rogowskispule 3, Halteteil 8 und Schirmplatte 9 in das Gehäuse 4 eingeführt. Fig. 5 stellt die entsprechenden Komponenten bzw. Baugruppen vor deren Zusammenführung dar. Das Vergussmittel 5 ist an diesem Zeitpunkt noch nicht ausgehärtet, und weist dabei vorgebbare Verformungsfähigkeit verbunden mit einer gewissen Zähigkeit auf. Insbesondere weist das Vergussmittel 5 eine Viskosität zwischen 1 Pa·s und 1000 Pa·s auf.

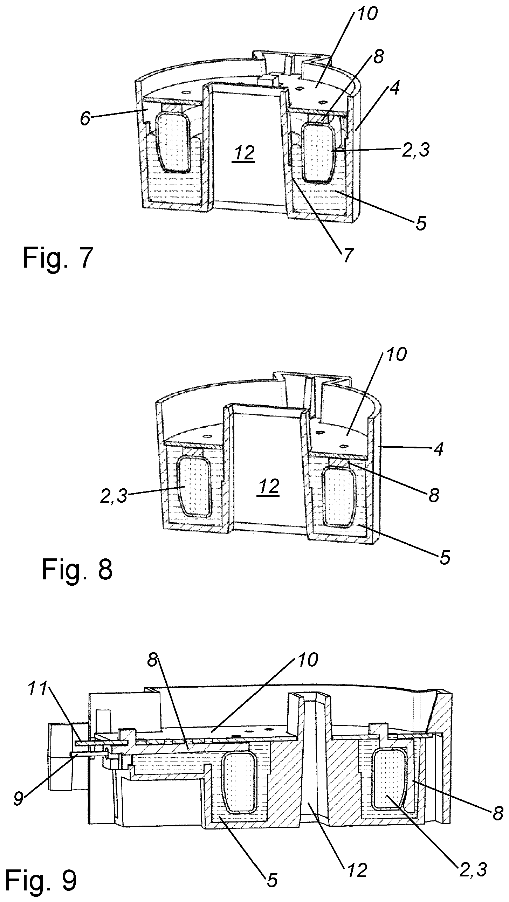

Durch den Druck wird das Vergussmittel 5 verformt und verschoben, und füllt dadurch weite Bereiche des Innenraumes des Gehäuses 4 aus. Fig. 6 zeigt die bereits zusammengebaute Stromsensorspulenanordnung 1. Die Fig. 7 und 8 zeigen zwei Teile dieses Vorganges, mit unterschiedlichen Positionen der entsprechenden Teile.

Bevorzugt ist vorgesehen, dass die Menge des Vergussmittels 5, welches in das Gehäuse 4 eingebracht wird, ausreichend groß ist, damit das Vergussmittel 5 im zusammengebauten Zustand die Schirmplatte 10 kontaktiert. Weiters ist bevorzugt, dass die Menge des Vergussmittels 5 ausreichend gering ist, um einzelne Bereiche der Rogowskispule 3 frei zu lassen bzw. nicht vollständig zu umhüllen, wenn sich die Rogowskispule 3 im eingebauten Endzustand in dem Gehäuse 4 befindet.

Bevorzugt ist vorgesehen, dass das Vergussmittel 5 wenigstens einen vorgebbaren Bereich 6 zwischen der Rogowskispule 3 und wenigstens einer Innenfläche 7 des Gehäuses 4 im Wesentlichen vollständig ausfüllt. Dadurch kann sowohl die mechanische Position der Rogowskispule 3 gesichert werden, als auch die abschirmende Wirkung der Vergussmasse 5. Insbesondere ist dabei vorgesehen, dass wenigstens zwei Drittel einer Außenfläche der Rogowskispule 3 von dem Vergussmittel 5 umschlossen, vorzugsweise berührt, sind. Dadurch wird die Abschirmung verbessert. Bevorzugt ist die wenigstens eine Innenfläche 7 ein zentraler Teil des Gehäuses, welcher die Öffnung 12 umgreift. Dieser Bereich ist auch in Fig. 7 bezeichnet.

Es wäre möglich, dass das Vergussmittel 5 die Rogowskispule 3 umgreift bzw. einpackt ohne diese selbst zu berühren bzw. zu kontaktieren. Es hat sich weiters als vorteilhaft für die abschirmende Wirkung der Vergussmasse 5 erwiesen, wenn das Vergussmittel 5 die Rogowskispule 3 an weiten Bereichen direkt kontaktiert.

Die Fig. 7, 8 und 9 zeigen jeweils Schnittdarstellungen der Stromsensorspulenanordnung 1. Dabei zeigt Fig. 7 eine Momentaufnahme während des Einbringens von Rogowskispule 3, Halteteil 8 und Schirmplatte 10 in das Gehäuse 4. Die Vergussmasse 5 befindet sich mitten in dem dabei auftretenden Umformvorgang, und berührt erst die Unterseite und die halben Seitenbereiche der Rogowskispule 3. Die Fig. 8 und 9 zeigen Schnitte nach dem beendeten Einführvorgang. Die Rogowskispule 3 ist von dem Vergussmittel 5, welches auch als Vergussmaterial, Vergussstoff oder Vergussmasse bezeichnet werden kann, umgeben. Dabei ist weiters auch gut erkennbar, wie das Vergussmittel 5 die Schirmplatte 10 kontaktiert.

Bevorzugt ist vorgesehen, dass das Vergussmittel 5 mit einem vorgebbaren elektrischen Potential elektrisch kontaktiert ist. Besonders bevorzugt ist daher vorgesehen, dass die Schirmplatte 10 einen Erdungsanschluss 11 aufweist, und das Vergussmittel 5 mit dem Erdungsanschluss 11 verbunden wird. Dadurch kann sichergestellt werden, dass das Vergussmittel 5 an einem elektrischen Potential anliegt und nur gering auf elektrische Wellen bzw. Strahlung bzw. Felder reagiert.

Die Fig. 10 zeigt die Anordnung aus Rogowskispule 3, Halteteil 8 und Schirmplatte 10 sowie weiters die umgebenden Teile des Gehäuses 4, welche gestrichelt dargestellt sind. Fig. 11 zeigt eine entsprechende Ansicht, wobei jedoch das Vergussmittel 5 ebenfalls dargestellt ist, welches die Rogowskispule 3 verdeckt.

Es ist vorgesehen, dass das Vergussmittel 5 einen spezifischen elektrischen Widerstand zwischen 500 Ω·cm und 5000 Ω·cm, vorzugsweise zwischen 2000 Ω·cm und 3000 Ω·cm, aufweist. Gemäß einer besonders bevorzugten Ausführungsform ist der spezifische elektrische Widerstand vorzugsweise zwischen 2400 Ω·cm und 2700 Ω·cm. Durch diese Eigenschaft kann die Messgenauigkeit bereits deutlich erhöht werden. Ein solcher Widerstand sorgt dafür, dass eingestrahlte Signale deutlich gedämpft und in dem Vergussmittel 5 gebunden werden. Neben der gegenwärtig verwendeten Einheit für den spezifischen elektrischen Widerstand: Ω·cm sind auch andere Einheiten, wie etwa Ω·mm²/m üblich bzw. verbreitet. Eine Umrechnung zwischen diesen Einheiten ist mathematisch einfach.

Bevorzugt ist zur Messung des spezifischen Widerstandes des Vergussmittels 5 vorgesehen, dass das Vergussmittel 5 in einem nicht ausgehärteten bzw. unausgehärteten Zustand zwischen zwei Elektroden eines Messaufbaues bzw. einer Messanordnung eingefüllt wird. Der betreffende Freiraum wird daher mit dem Vergussmittel 5 ausgegossen. Nachfolgend wird das Aushärten bzw. Verhärten des Vergussmittels 5 abgewartet. Danach wird der elektrische Widerstand zwischen diesen beiden Elektroden des Messaufbaues gemessen. Diese Widerstandsmessung erfolgt dabei bevorzugt in herkömmlicher Weise.

Weiters ist bevorzugt vorgesehen, dass der spezifische elektrische Widerstand des Vergussmittels 500- bis 2000-mal größer ist, als der spezifische elektrische Widerstand der Rogowskispule 3. Da die elektrische Leitfähigkeit invers bzw. umgekehrt proportional zum spezifischen elektrischen Widerstand ist, ist daher bevorzugt vorgesehen, dass das Vergussmittel 5 eine elektrische Leitfähigkeit aufweist, welche 500- bis 2000-mal kleiner als eine elektrische Leitfähigkeit der Rogowskispule 3 ist. Durch den höheren elektrischen Widerstand des Vergussmittels 5 im Vergleich zur der Rogowskispule 3 kann sichergestellt werden, dass - auch bei einem geringfügigen Leck an einer Außenfläche der Rogowskispule 3 - die Messgenauigkeit der Stromsensorspulenanordnung 1 praktisch nicht beeinträchtigt wird.

Der spezifische elektrische Widerstand, welcher von Fachleuten auch lediglich als spezifischen Widerstand bezeichnet wird, ist eine Material- bzw. Werkstoffeigenschaft. Der spezifische elektrische Widerstand ist keine Eigenschaft eines Bauteils, welcher bestimmte Abmessungen aufweist. Bei zahlreichen Werkstoffen, insbesondere bei Metallen, welche in der Elektrotechnik typischerweise für Leiter bzw. Spulen verwendet werden, also Kupfer, Aluminium und/oder Silber, ist jeweils der spezifische elektrische Widerstand bekannt. Der spezifische elektrische Widerstand des Werkstoffes bzw. der verwendeten Legierung ist vorzugsweise in einem Datenblatt des Herstellers des verwendeten Werkstoffes angegeben. Ansonsten ist der spezifische elektrische Widerstand bei einem drahtförmigen Leiter, aus welchem die Rogowskispule 3 typischerweise besteht, einfach messtechnisch ermittelbar. Dazu wird der Widerstand, die Querschnittsfläche und die Länge eines drahtförmigen Leiters gemessen, und daraus der spezifische elektrische Widerstand errechnet. Die Formel für diese Berechnung ist in elektrotechnischer Grundlagenliteratur bzw. entsprechenden Ausbildungs- bzw. Schulbüchern enthalten.

Der spezifische elektrische Widerstand des Vergussmittels 5 kann ebenfalls in einem entsprechenden Datenblatt angegeben sein. Alternativ dazu kann dieser jedoch auch messtechnisch angegeben werden. Dabei kann vorgesehen sein, dass in einem ersten Schritt eine Probe bzw. ein Teil des Vergussmittels 5, welche beispielsweise aus einer fertiggestellten Stromsensorspulenanordnung 1 entfernt wurde, auf dessen chemische Zusammensetzung und/oder auf dessen inneren Aufbau und/oder auf dessen Zustand hin untersucht wird. Auf Basis der Ergebnisse dieser Untersuchung kann ein Probenexemplar aus demselben Werkstoff hergestellt werden, welches Probenexemplar auch dieselbe innere Struktur und/oder denselben inneren Aufbau und/oder dieselbe werkstofftechnische Zusammensetzung wie die Probe bzw. der Teil des Vergussmittels 5 aufweist, der aus der Stromsensorspulenanordnung 1 entfernt wurde. Nach dessen Herstellung wird das Probenexemplar bevorzugt auf dessen chemische Zusammensetzung und/oder dessen inneren Aufbau und/oder dieselbe werkstofftechnische Zusammensetzung überprüft und kontrolliert, dass das Probenexemplar dementsprechend der Probe gleicht. Daraus ergibt sich, dass das Probenexemplar auch denselben spezifischen elektrischen Widerstand aufweist, wie besagte Probe aus dem Vergussmittel 5. Die Ermittlung des spezifischen elektrischen Widerstands des Vergussmittels 5 erfolgt dann auf Basis eines messtechnischen Verfahrens für Kunststoffe bzw. Elastomere. Insbesondere ist diesbezüglich ein Verfahren gemäß DIN IEC 60093 und/oder DIN EN 62631-3-1 vorgesehen. Bevorzugt ist zur Ermittlung des spezifischen elektrischen Widerstandes des Vergussmittels 5 vorgesehen, dass das Probenexemplar eine vorgebbare Formgebung und vorgebbare Abmessungen aufweist. Das Probenexemplar weist dabei eine ebene Form mit planparallelen Kontaktflächen auf. An diese Kontaktflächen werden zwei Plattenelektroden angeschlossen bzw. werden die Kontaktflächen zwischen die beiden Plattenelektroden eingespannt. Danach wird eine vorgebbare Spannung angelegt und der - durch das Probenexemplar fließende - elektrische Strom gemessen. Aus den direkten Messergebnissen sowie den bekannten Abmessungen kann dann der spezifische elektrische Widerstand ermittelt werden.

Die positive Wirkung der Vergussmasse 5 kann weiters noch dadurch gesteigert werden, dass diese bevorzugt im Wesentlichen nicht ferromagnetisch ist. Dadurch kann die Messfähigkeit bzw. Messgenauigkeit sichergestellt werden. Es hat sich gezeigt, dass ferromagnetische Werkstoffe zu einer Abschirmung der Rogowskispule 3 führen können und keine Strommessungen mehr erfolgen können.

Die Vergussmasse 5 weist wenigstens einen ersten Werkstoff und einen zweiten Werkstoff auf, welche sich unterscheiden und für sich genommen teilweise unterschiedliche Eigenschaften aufweisen, und welche zusammen jedoch Teil der Vergussmasse 5 sind.

Der erste Werkstoff ist bzw. umfasst einen elektrischen Isolierstoff. An sich kann jedes isolierende und vorgebbar verformbare Material als erster Werkstoff verwendet werden. Bevorzugt ist ein Isolierstoff ein Werkstoff bzw. ein Werkstoffverbund mit einer Leitfähigkeit, welche geringer als 1x10⁻¹¹ 1/Ω·cm ist. Vorzugsweise ist diese Leitfähigkeit zwischen 1x10⁻¹¹ 1 /Ω·cm und 1x10⁻¹³ 1/Ω·cm. Die betreffenden Werte für die Leitfähigkeit beziehen sich auf eine Mess-Temperatur von ca. 80 °C.

Insbesondere ist bzw. umfasst der erste Werkstoff bzw. der Isolierstoff Epoxid und/oder Polyurethan und/oder Silizium. Bevorzugt ist der erste Werkstoff im Wesentlichen zu weiten Teilen, insbesondere im Wesentlichen vollständig, aus einem dieser drei Materialien ausgebildet. Jeder dieser Werkstoffe hat sich als vorteilhaft für die Herstellung gegenständlicher Vergussmittel 5 und deren Lagerung und Verarbeitung in einem gegenständlichen Gehäuse 4 erwiesen. Ein bevorzugt verwendeter erster Werkstoff weist bei 80°C eine elektrische Leitfähigkeit von ca. 3,3 x10⁻¹¹ 1 /Ω·cm auf.

Besonders bevorzugt weist der erste Werkstoff noch wenigstens einen sog. Füllstoff auf. Als bevorzugte Füllstoffe haben sich unterschiedliche Mineralstoff, Korund, Aluminiumhydroxid und/oder unterschiedliche Quartverbindungen erwiesen.

Bevorzugt bildet der erste Werkstoff eine Basis bzw. einen Großteil des Vergussmittels 5 aus. Dabei ist insbesondere vorgesehen, dass der erste Werkstoff wenigstens 50%, vorzugsweise wenigstens 70%, insbesondere wenigstens 85%, des Gesamtgewichts des Vergussmittels 5 umfasst bzw. ausbildet. Besonders bevorzugt kann vorgesehen sein, dass bis zu 98% des Gesamtgewichts des Vergussmittels 5 durch den ersten Werkstoff gebildet sind. Die angegebenen Anteile bzw. Prozente des Gesamtgewichts sind bei einer Messungen der unterschiedlichen Werkstoffe unter gleicher bzw. identischer Erdanziehungskraft bzw. gleicher bzw. identischer Fallbeschleunigung identisch zu dem Anteil bzw. der Prozent der Masse.

Der zweite Werkstoff weist Partikel mit vorgebbarer elektrischer Leitfähigkeit auf bzw. handelt es sich bei den Partikeln um Materialien mit entsprechend ausreichender elektrischer Leitfähigkeit. Welcher Wert einer elektrischen Leitfähigkeit wenigstens ausreichend ist, hängt von unterschiedlichen Umgebungsparametern ab. Als vorteilhaft hat es sich erwiesen, wenn die einer elektrische Leitfähigkeit größer 0,04 m/Ω·mm² ist.

Gemäß einer ersten bevorzugten Ausführungsform der Partikel des zweiten Werkstoffs ist vorgesehen, dass die Partikel des zweiten Werkstoffs wenigstens einen vorgebbaren Ruß, insbesondere Azetylen-Ruß, umfassen bzw. sind. Dabei können auch andere Arten eines Rußes vorgesehen sein. Ruß hat sich dabei hinsichtlich seiner elektrischen und mechanischen Eigenschaften als besonders vorteilhaft erwiesen. Durch die Verwendung von Ruß kann ein ansonsten nicht leitfähiger Werkstoff gezielt und vorgebbar elektrisch leitfähig gemacht werden. Gleichzeitig kann ein vorgebbar hoher elektrischer Widerstand erzielt werden.

Ruß kann unterschiedliche Größenverhältnisse und Formen aufweisen. Bevorzugt ist vorgesehen, dass eine Mehrzahl der Rußteilchen eine BET von 60 m² bis 80 m² und einen Durchmesser von 30 nm bis 50 nm aufweisen.

Gemäß einer zweiten bevorzugten Ausführungsform der Partikel des zweiten Werkstoffs ist vorgesehen, dass die Partikel des zweiten Werkstoffs vorgebbare Metallfäden, insbesondere umfassend Kupfer und/oder Silber und/oder Aluminium, umfassen bzw. sind. All die bevorzugten Metalle weisen sehr hohe elektrische Leitfähigkeiten auf, und deren technische Eigenschaften und Verarbeitung sind dem Fachmann bekannt.

Gemäß einer dritten bevorzugten Ausführungsform der Partikel des zweiten Werkstoffs ist vorgesehen, dass die Partikel des zweiten Werkstoffs vorgebbare mineralische Fasern, insbesondere umfassend Graphit, umfassen bzw. sind. Besonders bevorzugt ist dabei vorgesehen, dass die Partikel des zweiten Werkstoffs als Fasern ausgebildet sind, welche zu mindestens 80% Kohlenstoff umfassen. Die Prozentangaben beziehen sich insbesondere auf Masseprozent. Kohlenstoff bzw. Graphit haben sich diesbezüglich als besonders vorteilhaft erwiesen. Aber auch einige Mineralien weisen eine ausreichend hohe Leitfähigkeit und entsprechende mechanische Eigenschaften auf.

Gemäß einer vierten bevorzugten Ausführungsform der Partikel des zweiten Werkstoffs ist vorgesehen, dass wenigstens zwei oder alle drei der vorstehend beschrieben bevorzugten Ausführungsformen kombiniert werden.

Der zweite Werkstoff ist insbesondere für die elektrische Leitfähigkeit und gleichzeitige Dämpfung der Vergussmasse 5 wichtig. Bevorzugt ist vorgesehen, dass der zweite Werkstoff zwischen 2% bis 10%, vorzugsweise im Wesentlichen 5%, des Gesamtgewichts der Vergussmasse 5 umfasst.

Weiters kann das Vergussmittel 5 noch weitere Werkstoffe enthalten, welche etwa als Härter dienen bzw. andere Eigenschaften, welche für die Verwendung des Vergussmittels 5 sinnvoll sind, erwirken.

Die Partikel des zweiten Werkstoffes haben - zusammen mit den Abmessungen von deren Umgebung - auch Einfluss auf die bereits angeführte Viskosität des Vergussmittels 5. Es hat sich gezeigt, dass bei einer Länge der Partikel von im Wesentlichen 6 mm bei deutlich größeren Abmessungen des umgebenden Gehäuses bzw. des Raumes, welcher mit der Vergussmasse vergossen wird bzw. wurde, die Viskosität zwischen 1 Pa·s und 100 Pa·s liegt. Weiters hat sich gezeigt, dass - bei denselben Abmessungen der Partikel - die Viskosität in einen Bereich zwischen 100 Pa·s und 1000 Pa·s liegt, wenn das umgebenden Gehäuse bzw. der betreffende Raum Abmessungen aufweist, welche in derselben oder einer ähnlichen Größenordnung liegen, wie die Abmessungen der Partikel. Dies ist beispielsweise gegeben, wenn sich die Vergussmasse 5 mit Partikeln mit einer Länge von ca. 6 mm in einem Rohr mit einem Durchmesser von ca. 2 mm befinden. Als Messverfahren zur Ermittlung der Viskosität ist bevorzugt vorgesehen, dass das Vergussmittel 5 in ein erstes Rohr einer Messanordnung mit einem Innendurchmesser von 70 mm eingefüllt wird. Ein Ende des ersten Rohres grenzt an ein zweites Rohr der Messanordnung mit einem Innendurchmesser von 2 mm. Das Vergussmittel 5 wird dann von dem ersten Rohr in das zweite Rohr gepresst. Das Vergussmittel 5 weist in dieser Messanordnung vorzugsweise eine Viskosität von 100 Pa·s und 1000 Pa·s auf.

Nachfolgend werden Grundsätze für das Verständnis und die Auslegung gegenständlicher Offenbarung angeführt.

Merkmale werden üblicherweise mit einem unbestimmten Artikel "ein, eine, eines, einer" eingeführt. Sofern es sich aus dem Kontext nicht anders ergibt, ist daher "ein, eine, eines, einer" nicht als Zahlwort zu verstehen.

Das Bindewort "oder" ist als inklusiv und nicht als exklusiv zu interpretieren. Sofern es sich aus dem Kontext nicht anders ergibt, umfasst "A oder B" auch "A und B", wobei "A" und "B" beliebige Merkmale darstellen.

Mittels eines ordnenden Zahlwortes, beispielweise "erster", "zweiter" oder "dritter", werden insbesondere ein Merkmal X bzw. ein Gegenstand Y in mehreren Ausführungsformen unterschieden, sofern dies nicht durch die Offenbarung der Erfindung anderweitig definiert wird. Insbesondere bedeutet ein Merkmal X bzw. Gegenstand Y mit einem ordnenden Zahlwort in einem Anspruch nicht, dass eine unter diesen Anspruch fallende Ausgestaltung der Erfindung ein weiteres Merkmal X bzw. einen weiteren Gegenstand Y aufweisen muss.

Ein "im Wesentlichen" in Verbindung mit einem Zahlenwert mitumfasst eine Toleranz von ± 10% um den angegebenen Zahlenwert, sofern es sich aus dem Kontext nicht anders ergibt.

Bei Wertebereichen sind die Endpunkte mitumfasst, sofern es sich aus dem Kontext nicht anders ergibt.

## Patentansprüche

1. Stromsensorspulenanordnung (1) umfassend wenigstens eine Sensor-Luftspule (2), welche Sensor-Luftspule (2) als Rogowskispule (3) ausgebildet ist, wobei die Stromsensorspulenanordnung (1) ein Gehäuse (4) aufweist, welches Gehäuse (4) die Rogowskispule (3) umfasst, wobei in dem Gehäuse ein Vergussmittel (5) angeordnet ist, wobei die Rogowskispule (3) in das Vergussmittel (5) eingebettet ist, **dadurch gekennzeichnet, dass** das Vergussmittel (5) wenigstens einen ersten Werkstoff und einen zweiten Werkstoff umfasst, dass der erste Werkstoff ein elektrischer Isolierstoff ist, dass der zweite Werkstoff Partikel mit vorgebbarer elektrischer Leitfähigkeit umfasst, und dass das Vergussmittel (5) einen spezifischen elektrischen Widerstand zwischen 500 Ω·cm und 5000 Ω·cm, vorzugsweise zwischen 2000 Ω·cm und 3000 Ω·cm, aufweist.

2. Stromsensorspulenanordnung (1) nach Anspruch 1, **dadurch gekennzeichnet, dass** das Vergussmittel (5) wenigstens einen vorgebbaren Bereich (6) zwischen der Rogowskispule (3) und wenigstens einer Innenfläche (7) des Gehäuses (4) im Wesentlichen vollständig ausfüllt.

3. Stromsensorspulenanordnung (1) nach Anspruch 1 oder 2, **dadurch gekennzeichnet, dass** wenigstens zwei Drittel einer Außenfläche der Rogowskispule (3) von dem Vergussmittel (5) umschlossen, vorzugsweise berührt, sind.

4. Stromsensorspulenanordnung (1) nach einem der Ansprüche 1 bis 3, **dadurch gekennzeichnet, dass** das Vergussmittel (5) einen spezifischen elektrischen Widerstand aufweist, welcher 500- bis 2000-mal größer als ein spezifischer elektrischer Widerstand der Rogowskispule (3) ist.

5. Stromsensorspulenanordnung (1) nach einem der Ansprüche 1 bis 4, **dadurch gekennzeichnet, dass** das Vergussmittel (5) im Wesentlichen nicht ferromagnetisch ist.

6. Stromsensorspulenanordnung (1) nach einem der Ansprüche 1 bis 5, **dadurch gekennzeichnet, dass** der zweite Werkstoff zwischen 2% bis 10%, vorzugsweise im Wesentlichen 5%, des Gesamtgewichts der Vergussmasse (5) umfasst.

7. Stromsensorspulenanordnung (1) nach einem der Ansprüche 1 bis 6, **dadurch gekennzeichnet, dass** die Partikel des zweiten Werkstoffs wenigstens ein vorgebbarer Ruß, insbesondere Azetylen-Ruß, und/oder vorgebbare Metallfäden, insbesondere umfassend Kupfer und/oder Silber und/oder Aluminium, und/oder vorgebbare mineralische Fasern, insbesondere umfassend Graphit, und/oder vorgebbare Kohlenstofffasern umfasst.

8. Stromsensorspulenanordnung (1) nach einem der Ansprüche 1 bis 7, **dadurch gekennzeichnet, dass** der erste Werkstoff wenigstens 50% der Gesamtmasse des Vergussmittels (5) umfasst.

9. Stromsensorspulenanordnung (1) nach einem der Ansprüche 1 bis 8, **dadurch gekennzeichnet, dass** der elektrische Isolierstoff des ersten Werkstoffs Epoxid und/oder Polyurethan und/oder Silizium umfasst.

10. Stromsensorspulenanordnung (1) nach einem der Ansprüche 1 bis 9, **dadurch gekennzeichnet, dass** das Vergussmittel (5) mit einem vorgebbaren elektrischen Potential, insbesondere einer Erdung, elektrisch kontaktiert ist.

11. Verfahren zur Herstellung einer Stromsensorspulenanordnung (1), insbesondere nach einem der Ansprüche 1 bis 10, wobei eine Rogowskispule (3) an einem Halteteil (8) befestigt wird, wobei die Rogowskispule (3) an elektrische Verbindungsmittel (9) der Stromsensorspulenanordnung (1) angeschlossen wird, wobei die angeschlossene Rogowskispule (3) zusammen mit dem Halteteil (8) einseitig mit einer Schirmplatte (10) verbunden wird, wobei eine vorgebbare Menge eines Vergussmittels (5), welches Vergussmittel (5) wenigstens einen ersten Werkstoff und einen zweiten Werkstoff umfasst und welches einen spezifischen elektrischen Widerstand zwischen 500 Ω·cm und 5000 Ω·cm aufweist in ein Gehäuse (4) der Stromsensorspulenanordnung (1) eingeführt wird, wobei der erste Werkstoff ein elektrischer Isolierstoff ist, wobei der zweite Werkstoff Partikel mit vorgebbarer elektrischer Leitfähigkeit umfasst, wobei nachfolgend die Anordnung aus angeschlossener Rogowskispule (3), Halteteil (8) und Schirmplatte (10) in das Gehäuse (4) eingeführt und gegen das Vergussmittel (5) gepresst wird, wobei das Vergussmittel (5) verformt wird und ein Volumen zwischen der Rogowskispule (3) und einer Innenfläche (7) des Gehäuses (4) in vorgebbarem Maße ausfüllt.

12. Verfahren nach Anspruch 11, **dadurch gekennzeichnet, dass** die Rogowskispule (3) vor deren Einbringen in das Gehäuse (4) elektrisch überprüft wird.

13. Verfahren nach Anspruch 11 oder 12, **dadurch gekennzeichnet, dass** die Schirmplatte (10) einen Erdungsanschluss (11) aufweist, und das Vergussmittel (5) mit dem Erdungsanschluss (11) verbunden wird.

14. Verfahren nach einem der Ansprüche 11 bis 13, **dadurch gekennzeichnet, dass** die Menge des - in das Gehäuse (4) eingebrachten - Vergussmittels (5) ausreichend groß ist, dass das Vergussmittel (5) - im zusammengebauten Zustand - die Schirmplatte (10) kontaktiert.

15. Verfahren nach einem der Ansprüche 11 bis 14, **dadurch gekennzeichnet, dass** das - noch nicht ausgehärtete - Vergussmittel (5) eine Viskosität zwischen 1 Pa·s und 1000 Pa·s, insbesondere zwischen1 Pa·s und 100 Pa·s oder zwischen 100 Pa·s und 1000 Pa·s, aufweist.

## Claims

1. A current sensor coil assembly (1) comprising at least one sensor air coil (2), which sensor air coil (2) is designed as a Rogowski coil (3), wherein the current sensor coil assembly (1) has a housing (4), which housing (4) comprises the Rogowski coil (3), wherein a potting compound (5) is arranged in the housing, the Rogowski coil (3) is embedded in the potting compound (5), **characterized in that in that** the potting compound (5) comprises at least one first material and one second material, **in that** the first material is an electrical insulating material, **in that** the second material comprises particles having pre-determinable electrical conductivity, and **in that** the potting compound (5) has a specific electric resistance between 500 Ω·cm and 5000 Ω·cm, preferably between 2000 Ω·cm and 3000 Ω·cm.

2. The current sensor coil assembly (1) as claimed in claim 1, **characterized in that** the potting compound (5) essentially completely fills up at least one predeterminable area (6) between the Rogowski coil (3) and at least one inner surface (7) of the housing (4).

3. The current sensor coil assembly (1) as claimed in claim 1 or 2, **characterized in that** at least two thirds of an outer surface of the Rogowski coil (3) is enclosed, preferably touched, by the potting compound (5).

4. The current sensor coil assembly (1) as claimed in any one of claims 1 to 3, **characterized in that** the potting compound (5) has a specific electrical resistance which is 500 to 2000 times greater than a specific electric resistance of the Rogowski coil (3).

5. The current sensor coil assembly (1) as claimed in any one of claims 1 to 4, **characterized in that** the potting compound (5) is essentially non-ferromagnetic.

6. The current sensor coil assembly (1) as claimed in any one of claims 1 to 5, **characterized in that** the second material comprises between 2% to 10%, preferably essentially 5%, of the total weight of the potting compound (5).

7. The current sensor coil assembly (1) as claimed in any one of claims 1 to 6, **characterized in that** the particles of the second material comprise at least one predeterminable carbon black, in particular acetylene carbon black, and/or predeterminable metal threads, in particular comprising copper and/or silver and/or aluminum, and/or predeterminable mineral fibers, in particular comprising graphite, and/or predeterminable carbon fibers.

8. The current sensor coil assembly (1) as claimed in any one of claims 1 to 7, **characterized in that** the first material comprises at least 50% of the total mass of the potting compound (5).

9. The current sensor coil assembly (1) as claimed in any one of claims 1 to 8, **characterized in that** the electrical insulating material of the first material comprises epoxy and/or polyurethane and/or silicon.

10. The current sensor coil assembly (1) as claimed in any one of claims 1 to 9, **characterized in that** the potting compound (5) is electrically contacted with a predeterminable electrical potential, in particular a ground.

11. A method for producing a current sensor assembly (1), in particular as claimed in any one of claims 1 to 10, wherein a Rogowski coil (3) is fastened on a holding part (8), wherein the Rogowski coil (3) is connected to electrical connecting means (9) of the current sensor coil assembly (1), wherein the connected Rogowski coil (3) together with the holding part (8) is connected on one side to a shielding plate (10), wherein a pre-determinable amount of a potting compound (5), which potting compound (5) comprises at least one first material and one second material and which has a specific electric resistance between 500 Ω·cm and 5000 Ω·cm is introduced into a housing (4) of the current sensor coil assembly (1), wherein the first material is an electrical insulating material, wherein the second material comprises particles having predeterminable electrical conductivity, wherein then the assembly made up of connected Rogowski coil (3), holding part (8), and shielding plate (10) is introduced into the housing (4) and pressed against the potting compound (5), wherein the potting compound (5) is deformed and fills up a volume between the Rogowski coil (3) and an inner surface (7) of the housing (4) to a pre-determinable extent.

12. The method as claimed in claim 11, **characterized in that** the Rogowski coil (3) is electrically checked before its introduction into the housing (4).

13. The method as claimed in claim 11 or 12, **characterized in that** the shielding plate (10) has a ground connection (11), and the potting compound (5) is connected to the ground connection (11).

14. The method as claimed in any one of claims 11 to 13, **characterized in that** the amount of the potting compound (5) - introduced into the housing (4) - is sufficiently large that the potting compound (5) - in the assembled state contacts the shielding plate (10).

15. The method as claimed in any one of claims 11 to 14, **characterized in that** the potting compound (5) - which is not yet cured - has a viscosity between 1 Pa-s and 1000 Pa-s, in particular between between 1 Pa-s and 100 Pa s or between 100 Pa s and 1000 Pa s.

## Revendications

1. L'ensemble bobine capteur de courant (1) comprend au moins une bobine d'air capteur (2), laquelle bobine d'air capteur (2) est conçue comme une bobine de Rogowski (3), dans lequel l'ensemble bobine capteur de courant (1) a un boîtier (4), lequel boîtier (4) comprend la bobine de Rogowski (3), dans lequel un composé d'empotage (5) est disposé dans le boîtier, la bobine de Rogowski (3) est encastrée dans le composé d'empotage (5), **caractérisé en ce que** le composé d'enrobage (5) comprend au moins un premier matériau et un second matériau, **en ce que** le premier matériau est un matériau isolant électrique, **en ce que** le second matériau comprend des particules ayant une conductivité électrique prédéterminée, et **en ce que** le composé d'enrobage (5) a une résistance électrique spécifique comprise entre 500 Ω·cm et 5000 Ω·cm, de préférence entre 2000 Ω·cm et 3000 Ω·cm.

2. L'ensemble bobine capteur de courant (1) selon la revendication 1, **caractérisé en ce que** le composé d'empotage (5) remplit essentiellement complètement au moins une zone prédéterminable (6) entre la bobine de Rogowski (3) et au moins une surface intérieure (7) du boîtier (4).

3. L'ensemble bobine capteur de courant (1) selon la revendication 1 ou 2, **caractérisé par le fait qu'**au moins deux tiers d'une surface extérieure de la bobine de Rogowski (3) sont enfermés, de préférence touchés, par le composé d'empotage (5).

4. L'ensemble bobine capteur de courant (1) selon l'une quelconque des revendications 1 à 3, **caractérisé en ce que** le composé d'empotage (5) a une résistance électrique spécifique qui est de 500 à 2000 fois supérieure à une résistance électrique spécifique de la bobine de Rogowski (3).

5. L'ensemble bobine capteur de courant (1) selon l'une quelconque des revendications 1 à 4, **caractérisé par le fait que** le composé d'enrobage (5) est essentiellement non ferromagnétique.

6. L'ensemble bobine capteur de courant (1) selon l'une quelconque des revendications 1 à 5, **caractérisé par le fait que** le second matériau représente entre 2 % et 10 %, de préférence essentiellement 5 %, du poids total du composé d'enrobage (5).

7. L'ensemble bobine capteur de courant (1) selon l'une quelconque des revendications 1 à 6, **caractérisé en ce que** les particules du second matériau comprennent au moins un noir de carbone prédéterminable, en particulier un noir de carbone acétylène, et/ou des fils métalliques prédéterminables, en particulier comprenant du cuivre et/ou de l'argent et/ou de l'aluminium, et/ou des fibres minérales prédéterminables, en particulier comprenant du graphite, et/ou des fibres de carbone prédéterminables.

8. L'ensemble bobine capteur de courant (1) selon l'une quelconque des revendications 1 à 7, **caractérisé en ce que** le premier matériau comprend au moins 50 % de la masse totale du composé d'empotage (5).

9. L'ensemble bobine capteur de courant (1) selon l'une des revendications 1 à 8, **caractérisé par le fait que** l'isolant électrique du premier matériau comprend de l'époxy et/ou du polyuréthane et/ou du silicium.

10. L'ensemble bobine capteur de courant (1) selon l'une quelconque des revendications 1 à 9, **caractérisé par le fait que** le composé d'empotage (5) est en contact électrique avec un potentiel électrique prédéterminé, en particulier une masse.

11. Procédé de fabrication d'un ensemble capteur de courant (1), en particulier selon l'une quelconque des revendications 1 à 10, dans lequel une bobine de Rogowski (3) est fixée sur une pièce de maintien (8), dans lequel la bobine de Rogowski (3) est connectée à des moyens de connexion électrique (9) de l'ensemble bobine capteur de courant (1), dans lequel la bobine de Rogowski connectée (3) ainsi que la pièce de maintien (8) sont connectées d'un côté à une plaque de blindage (10), dans lequel une quantité prédéterminée d'un composé d'empotage (5), lequel composé d'empotage (5) comprend au moins un premier matériau et un second matériau et qui a une résistance électrique spécifique entre 500 Ω·cm et 5000 Ω·cm, est introduite dans un boîtier (4) de l'ensemble de bobine de capteur de courant (1), Dans lequel le premier matériau est un matériau isolant électrique, dans lequel le second matériau comprend des particules ayant une conductivité électrique prédéterminable, dans lequel ensuite l'ensemble composé de la bobine de Rogowski connectée (3), de la pièce de maintien (8) et de la plaque de blindage (10) est introduit dans le boîtier (4) et pressé contre le composé d'empotage (5), dans lequel le composé d'empotage (5) est déformé et remplit un volume entre la bobine de Rogowski (3) et une surface intérieure (7) du boîtier (4) dans une mesure prédéterminable.

12. Procédé selon la revendication 11, **caractérisé par le fait que** la bobine de Rogowski (3) est contrôlée électriquement avant d'être introduite dans le boîtier (4).

13. Procédé selon la revendication 11 ou 12, **caractérisé par le fait que** la plaque de blindage (10) possède une connexion à la terre (11) et que le composé d'empotage (5) est connecté à la connexion à la terre (11).

14. Procédé selon l'une quelconque des revendications 11 à 13, **caractérisé par le fait que** la quantité de composé d'empotage (5) - introduite dans le boîtier (4) - est suffisamment importante pour que le composé d'empotage (5) - à l'état assemblé - entre en contact avec la plaque de blindage (10).

15. Procédé selon l'une quelconque des revendications 11 à 14, **caractérisé en ce que** le composé d'empotage (5) - qui n'est pas encore durci - a une viscosité comprise entre 1 Pa s et 1000 Pa s, en particulier entre 1 Pa s et 100 Pa s ou entre 100 Pa s et 1000 Pa s.
